# EUROPEAN PATENT SPECIFICATION

(11) **EP 1 794 789 B1**
(45) Date of publication and mention of the grant of the patent: **15.12.2010**
(21) Application number: 05801275.8
(22) Date of filing: 27.09.2005
(51) Int. Cl.: H01L 21/762, H01L 21/764

(54) **STRUCTURES FOR MICROELECTRONICS AND MICROSYSTEM AND MANUFACTURING PROCESS**
STRUKTUREN FÜR MIKROELEKTRONIK UND MIKROSYSTEM SOWIE HERSTELLUNGSVERFAHREN
STRUCTURES DESTINEES A DES APPLICATIONS DE MICROELECTRONIQUE ET DE MICROSYSTEMES ET PROCEDE DE FABRICATION ASSOCIE

(30) Priority: 30.09.2004 FR 0452217; 22.04.2005 US 673801 P
(43) Date of publication of application: 13.06.2007
(73) Proprietor: S.O.I.TEC Silicon on Insulator Technologies, 38190 Bemin (FR)
(72) Inventor: ASPAR, Bernard, F-38140 RIVES (FR)
(74) Representative: Poulin, Gérard
(86) International application number: PCT/EP2005/054854
(87) International publication number: WO 2006/035031

(56) References cited:
- WO-A-01/93325
- WO-A-2004/059725
- US-A- 4 710 794
- US-A- 4 956 314
- US-A- 5 466 630
- US-A- 5 972 758
- US-A1- 2003 096 506
- US-A1- 2004 065 931
- US-A1- 2004 081 805
- US-B1- 6 171 923
- US-B1- 6 727 186
- YUN C H ET AL: "SOI on buried cavity patterns using ion-cut layer transfer" SOI CONFERENCE, 1998. PROCEEDINGS., 1998 IEEE INTERNATIONAL STUART, FL, USA 5-8 OCT. 1998, NEW YORK, NY, USA,IEEE, US, 5 October 1998 (1998-10-05), pages 165-166, XP010309922 ISBN: 0-7803-4500-2

## Description

### Technical domain and prior art

The invention relates to manufacturing of structures for semiconducting components or MEMS type devices and particularly SOI devices or SOI type devices.

Many MEMS (Micro Electro Mechanical Systems) microsystems are made using SOI (Silicon On Insulator) materials that in particular can be used to obtain monocrystalline silicon membranes suspended above a cavity.

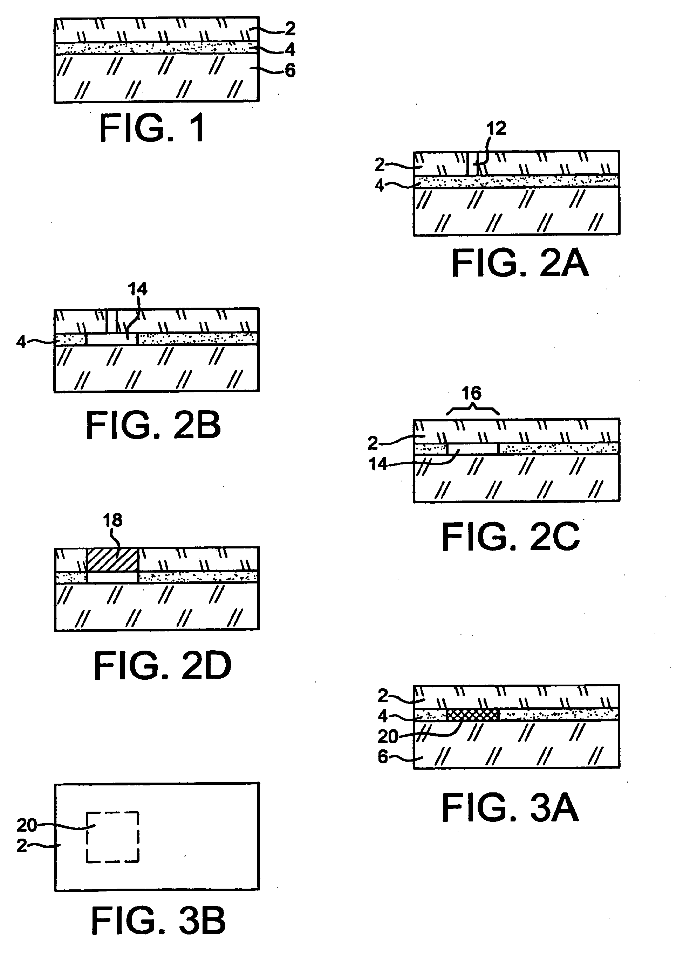

SOI type materials are structures composed of a surface layer 2 made of monocrystalline silicon on an insulating layer 4, usually a silicon oxide (Figure 1). For example, these structures are obtained by assembling a silicon wafer 6 oxidized on the surface with another silicon wafer by molecular bonding.

This assembly comprises a step for surface preparation of the two wafers, a step bringing the wafers into contact, and a heat treatment step. Conventionally, this heat treatment is done for 2 h at temperatures typically between 900° and 1250°C.

At least one of the two wafers is then thinned, leaving a thin semiconducting layer 2 on an insulating layer 4.

A thin suspended membrane, for example made of monocrystalline silicon, is sometimes necessary to manufacture some microsystems.

Component manufacturers often use wafers of SOI materials to obtain such a membrane. They use the surface layer as the active layer to make the devices, and the buried oxide layer as a sacrificial layer.

For example, an opening 12 is made in the surface silicon 2 so that the buried oxide layer 4 can be etched (Figure 2A).

This buried oxide is usually chemically etched, for example with HF, which causes the formation of a cavity 14 in the layer 4 (Figure 2B).

The hole 12 can then remain open or it may be closed again (Figure 2C), for example by deposition of a material (for example silicon). The result is thus a suspended membrane 16 made in the layer 2, and on or in which a microsystem 18 (Figure 2D) may be made.

It is usually difficult to control etching of the buried layer. In particular, problems may arise during chemical etching, etching solutions may vary as a function of the temperature or the pH, which makes it difficult to control the etched hole and its dimensions.

Another problem that arises with this technique is that it is impossible to make an arbitrarily shaped cavity, for example a square or rectangular or polygonal shaped cavity, in the plane of the layer 2, starting from the circular hole formed by the opening 12.

Chemical etching is isotropic in principle, and is done concentrically about the central hole defined by the opening 12.

It is possible to attempt to use several holes 12 in order to obtain a shape vaguely resembling a rectangle, but it is then very difficult to obtain right angles.

Therefore the problem arises of finding a new process for making suspended membranes and therefore cavities, particularly with technologies using SOI wafers.

The same problem also arises for the manufacture of membranes made of a piezoelectric or pyro-electric or magnetic material above the cavities.

Another problem that arises is to be able to make suspended cavities or membranes in a structure comprising a surface and possibly semiconducting layer, but that may also be a piezoelectric, pyro-electric or magnetic type, a buried layer, and a support or a subjacent layer acting as a support.

Another problem that arises is the mechanical stability of the assembly formed after the cavities have been produced.

Therefore, the problem that arises is to find a new structure of the type including a surface layer, possibly semiconducting, but which may also be of the piezoelectric, pyro-electric or magnetic type, a buried layer and a support or subjacent layer acting as a support, and means of mechanically reinforcing such a structure.

Document WO2004/059725 discloses a method of the production of cavities in a silicon sheet. It comprises an atomic implantation step through at least a part of the insulation layer and an engraving step for the insulation layer in at least a part of said layer affected by the atomic implantation.

### Presentation of the invention

The invention can be used to make a structure composed of a surface layer which in particular may be semiconducting, or of the piezoelectric, or pyro-electric or magnetic type, a buried layer comprising at least one cavity of any shape, and a support or a subjacent layer acting as a support.

The invention relates to a process for making a structure comprising a surface layer, at least one buried layer and a support comprising:
- a step to make a first structure, including the formation of at least one first layer made of a first material on a first support, and at least one area in this first layer made of a second material with an etching rate different from the etching rate of the first material,
- a step for the formation of the surface layer, by assembly of the first structure with a second support, and possibly thinning of at least one of the two supports.

Therefore, the shape of the area(s) composed of the material with the highest etching rate is defined before the surface layer is formed, so that this shape can be chosen arbitrarily and therefore the shape of the cavity in the buried layer during subsequent etching of this material with a higher etching rate can be determined in advance.

This provides good flexibility with the choice of shapes and relaxes etching conditions of the layer or the area to be etched, or reduces dependence on these conditions.

The buried layer made of a first material contains at least one area composed of at least one second material which is preferably chosen for its behaviour different from the behaviour of the first material with regard to subsequent etching; its etching rate is different from the etching rate of the first material.

Etching, for which the first and second materials have different etching rates, may be done with a reagent. Dry or wet etching may be used. Chemical etching is also possible, for example by HF if an oxide such as SiO₂ is being etched, or by RIE (reactive ionic etching) type etching.

The first step may comprise etching of the first layer to form at least one cavity, followed by deposition of the second material in the cavity(ies) thus formed.

For example, the assembly may be made by molecular bonding or by gluing.

If the assembly is made by molecular bonding, the surfaces may be prepared before they are brought into contact so that their surface properties are compatible with this bonding. For example, a levelling treatment may be applied to achieve good surface properties (roughness, planeness, and few particles, etc.).

Therefore, an intermediate structure is obtained using the process according to the invention, before etching of areas with the highest rate, the area made of a second material being made before two elements to be assembled are brought into contact or assembled.

A process according to the invention may also include a step to produce at least one opening in the surface layer, opening up in the area made from a material with the highest etching rate, then etching of this material to form at least one cavity in the buried layer, this cavity having a predetermined shape as described above.

Therefore, the cavity may have any shape defined by the shape of the area(s) made from the second material, for example a circular or square or rectangular or polygonal or elliptical shape or with at least one right angle in a plane parallel to the plane of the subjacent and surface layers.

Therefore, a process according to the invention is particularly suitable for obtaining membranes suspended at or above buried areas or cavities, occupied by the material with the highest etching rate before etching.

A process according to the invention may also comprise a step for formation of all or part of an electronic or microelectronic or electro-mechanical or MEMS component in the surface layer.

According to one embodiment, the second material has a higher etching rate than the first material.

The surface layer may be made by assembly of the first layer with the second support.

According to another embodiment, the second material has a lower etching rate than the first material.

A step can then be included for the formation of a second uniform layer made of a third material with a lower etching rate than the first material, on the first layer including the first and second materials.

This second layer, and the islands made of the second material remaining after the first material has been etched, will form mechanical resistance and anchorage means for the surface layer.

Furthermore, the second layer may be uniformly levelled more easily than in the previous embodiment in which a levelling step is carried out on an heterogeneous surface in which areas of the first material and areas of the second material are exposed.

According to this second embodiment, the second and third materials may be identical and deposited during the same step.

The first structure with the support, the first layer comprising areas of materials with different etching rates, and the second layer, is then assembled with the second support, the second layer also becoming a buried layer.

A polishing step can then be done before formation of the surface layer, but this step gives a particularly good result when a second layer made of a material with an etching rate lower than the etching rate of the first material, is made on the first buried layer, since levelling is then done on this second buried layer that is uniform.

The invention also relates to a device comprising a surface layer, a buried layer made of a first material, and a support, the buried layer comprising at least one area made of a second material with an etching rate different from the etching rate of the first material.

At least one of the areas made of a second material may have a circular or square or rectangular or polygonal or elliptical shape, or may have at least one right angle in a plane parallel to the plane of the buried and surface layers.

According to one embodiment, the second material has an etching rate greater than the etching rate of the first material.

According to another embodiment, the second material has an etching rate lower than the etching rate of the first material.

A second buried layer may then be provided made of a third material with an etching rate also with a lower etching rate than the first material, the second and third materials possibly being identical.

The invention also relates to a semiconducting device with a surface layer, a buried layer made of a first material and a subjacent layer acting as a support, the buried layer comprising at least one cavity with a square or rectangular or polygonal or elliptical shape or with at least one right angle in a plane parallel to the plane of the buried and surface layers.

It also relates to a semiconducting device with a surface layer, a first buried layer comprising areas made of a first material and at least one cavity, a second buried layer made of a second material and a support.

In a process or a device according to the invention, the first material may for example be made of silicon dioxide or thermal silica or polycrystalline silicon or amorphous silicon or silicon nitride.

For example, the other material may be made of Si₃N₄ or doped silicon oxide of the BPSG or PSG type or SiO₂.

This second material is chosen so that its behaviour when etched is different from the first material. Thus, SiO₂ might be chosen as the material with the lower etching rate for one type of etching, while it will have a higher etching rate for another type of etching.

The buried layer may be composed of silica areas with Si₃N₄ areas, or thermal silica areas with silicon oxide areas of the BPSG or the PSG type.

According to one example, the buried layer is formed from silicon dioxide to be etched and areas made of polycrystalline silicon (for which the etching rate is lower than the etching rate of Si dioxide, particularly for chemical etching with HF), and the second buried layer is also made of polycrystalline Si.

The surface layer may be made of a semiconductor, for example silicon or germanium, or a III-V, II-VI semiconductor or a semiconductor compound for example such as SiGe or a piezoelectric or pyro-electric or magnetic material.

The structure obtained may be an SOI type structure, in other words composed of a semiconducting material and a buried layer with different properties (for example electrical or physical or chemical).

The substrate may also be semiconducting.

### Brief description of the Figures

Figure 1 represents an SOI structure.
Figures 2A - 2D represent steps in a process according to prior art.
Figures 3A and 3B represent a component according to the invention, showing a side view and a top view respectively.
Figures 4A - 4G represent steps in the process according to the invention.
Figures 5A - 5G represent steps in another process according to the invention.

### Detailed description of particular embodiments

Figure 3A represents a component according to the invention comprising a buried layer 4 initially made of a first material, and a surface layer 2 for example made of silicon or germanium, or an III-IV semiconductor or an II-VI semiconductor or a semiconductor compound for example such as SiGe, on a substrate 6.

This layer 2 may also be made of a piezoelectric or pyro-electric or magnetic material.

For example, the thickness of layer 4 is between 50 nm and a few µm, for example 10 µm and the thickness of layer 2 is between 10 nm and a few tens of µm, for example 100 µm. These thicknesses may vary outside the ranges indicated.

The buried layer 4 will contain one or several buried areas 20 made of a second material different from the first material in layer 4, the essential difference from layer 4 being in terms of its behaviour during subsequent etching such as dry etching or wet etching; for a given type of etching, the etching rate of the material in area 20 (second material) is higher than the etching rate of the first material and of the material in the surface layer.

In other words, as explained above with reference to Figure 2A, making an opening 12 will make it possible to preferentially etch this area 20 with an etching rate greater than the etching rate of the material in layer 4. For example, the ratio of the etching rates of the second and first materials is greater than 1 or 2, or is between 2 and 10 or between 10 and 1000 and possibly even more than 1000.

Table I below gives typical example etching rates for some materials and some chemical etching solutions:

**Table I**

| | CHEMICAL ETCHING SOLUTIONS | | | |
|---|---|---|---|---|
| | TMAH 25% 80°C | HF 5% 20°C | HF 50% 20°C | H₃PO₄ 160°C |
| Si | ∼ 500 nm/min | < 0.5 nm/min | < 1 nm/min | ∼ 0.2 nm/min |
| SiO₂ | < 0.5 nm/min | 20-40 nm/min | ∼ 500 nm/min | < 0.1 nm/min |
| Si₃N₄ | < 0.5 nm/min | ∼ 0.8 nm/min | < 20 nm/min | ∼ 5 nm/min |

The area 20 is shown in a side view in Figure 3A. But as illustrated in Figure 3B (which is a top view of the component in Figure 3A), it may be a square in a plane parallel to a principal plane of the component or the layer 4, or it may be any other shape in the same plane: circular, polygonal, elliptical, etc. Therefore, to the extent that etching will act preferentially on the material in this area 20, it will be possible to make an arbitrary shaped cavity, and particularly square or circular or polygonal or elliptical cavity, etc.

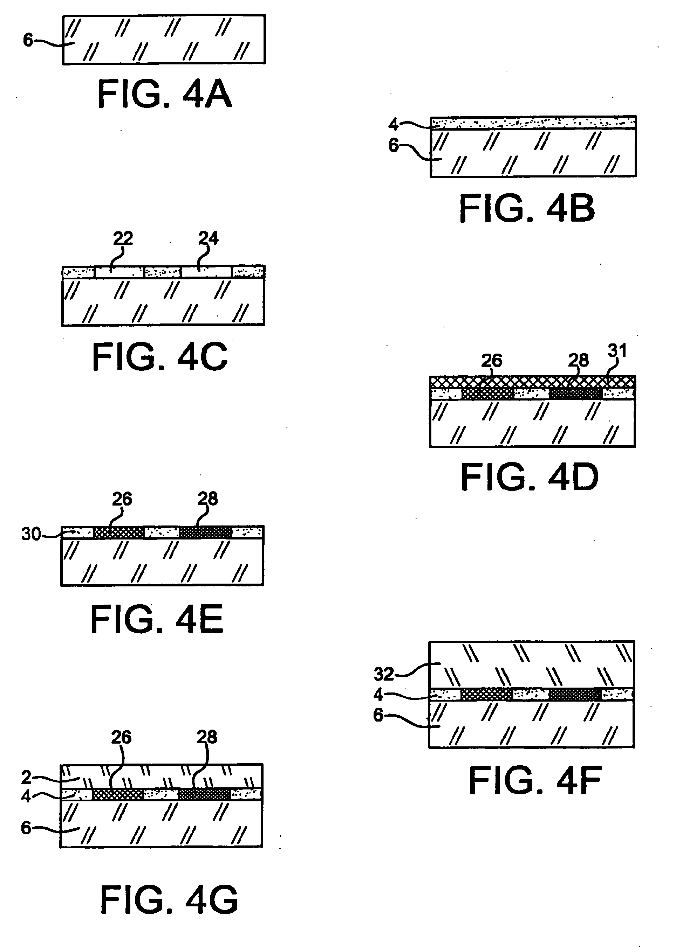

We will now describe a method of making such a component with reference to Figures 4A to 4G.

A first layer 4 made of a first material (Figure 4B), for example an insulating material such as silicon oxide (SiO₂) that can be obtained by thermal oxidation, is made on a blank silicon wafer 6 (Figure 4A). For example, the thickness of this layer is about 1 µm.

Areas 22 and 24 are defined on this wafer 6 by masking and lithography, and these areas will correspond to the areas of future cavities (Figure 4C), for example by chemical etching (for example using 10% HF) or RIE etching.

The thermal oxide is etched in these areas so as to completely eliminate this oxide and form these cavities.

A second material 26, 28 (Figure 4D) is then deposited in these cavities and is etched at rates greater than the etching rates of the thermal oxide 4.

For example, this material may be silicon oxide deposited by CVD which has a different density from the thermal oxide or which has a different chemical composition from the thermal oxide.

This material may also for example be a PSG (Phosphorus doped Spin on Glass) or BPSG (Boron Phosphorus doped Spin on Glass) doped oxide for example with 4% to 6% of P or containing a few % of B.

A material completely different from the oxide in layer 4 could also be used, for example silicon nitride. A H₃PO₄ solution will etch this material preferentially rather than the oxide.

This deposition step may have left a layer or film 31 on the surface. Therefore, the surface 30 of the structure can be levelled (Figure 4E) so as to have only an alternation of areas made of a first material and areas 26, 28 made of a second material that is more easily etched than the first layer, in the future buried layer, with no layer or film on the surface.

Levelling is preferably such that the surfaces of the two areas formed from the two materials (firstly the material in layer 4 and secondly the material in areas 22, 24), are at the same level with no surface layer 31.

In some cases, a small thickness of a single material (for example 20 nm) may remain on the surface of the entire structure, but this does not create any problem in obtaining the final structure.

This wafer thus prepared is then bonded onto or assembled with another wafer 32 that may for example be made of blank silicon (Figure 4F).

In one variant, two wafers may be assembled with areas defined on each. For example, the surface of wafer 32 comprises components that have already been made and will come into contact with the areas under which the cavities will be made (on the side that will be assembled with layer 4). In the latter case, the two wafers can be aligned with each other.

The result is then a structure with a "structured" buried layer 4 comprising a support on which there are areas filled with a material 26, 28 that can be etched more easily than the initial material from which the buried layer 4 is made.

According to one variant, at least one of the two wafers 6, 32 may be thinned to obtain a membrane 2 (Figure 4G) of the required thickness, for example made of monocrystalline silicon.

One of more wafers may be thinned using different means chosen for example from among mechanical thinning and / or mechanical - chemical and / or chemical thinning, and / or thinning by cleavage and / or fracture by heat treatment at a buried plane weakened by the creation of ions (for example hydrogen) or by the creation of porosities. These techniques can be used independently or they may be combined.

Thus, one of the two wafers can be thinned for example by grinding followed by mechanical - chemical polishing to obtain a membrane 2 with a final thickness of 20 µm.

The component or the substrate obtained can be used as an initial material for making a microsystem 18 using the technique described above with reference to Figures 2A - 2D. Thus, due to the presence of the material 26, 28 in the buried layer, the process for obtaining buried cavities is simpler than in prior art and in particular, can be used to produce much better controlled geometries in the plane of the layer 4, and particularly geometries with any shape such as square or rectangular, or elliptical or any other shape defined by the lithography and etching step of layer 4.

The above description relates to the example of one cavity (Figure 3A) and two cavities (Figures 4D-4G) in layer 4, but any number of cavities with different shapes may be made in the same layer.

Furthermore, two cavities in the same layer may be filled with different materials, these two materials having different etching characteristics from the material in layer 4, and particularly etching rates greater than the etching rate of layer 4.

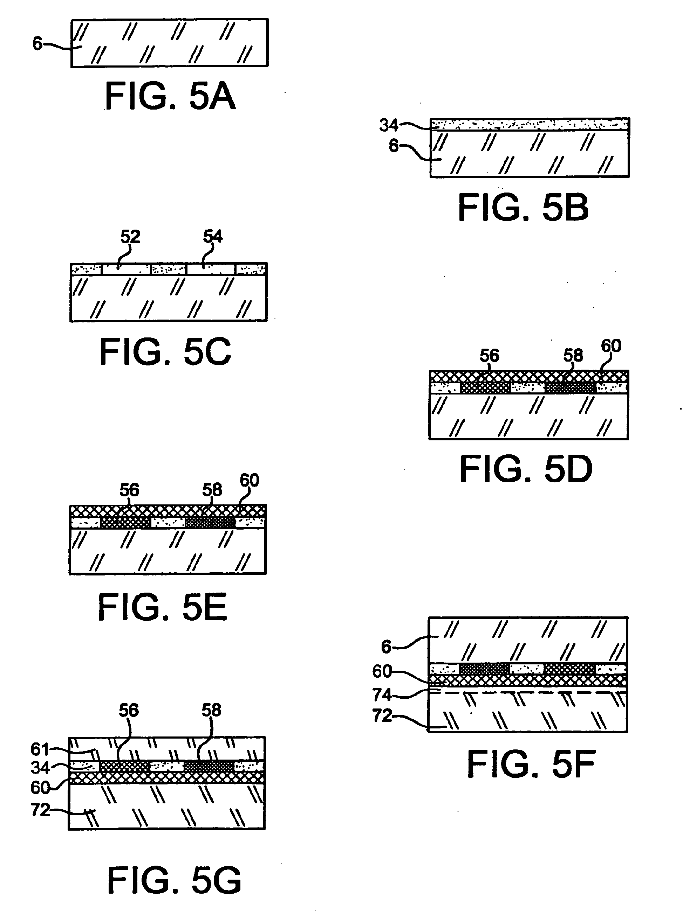

Figure 5G shows another component according to the invention, consisting of a substrate 72 under a first buried layer 60 and a second buried layer 34 initially made of a first material, and a surface layer 61, for example made of silicon or germanium, or a III-IV or II-VI semiconductor or a semiconductor compound such as SiGe.

This layer 61 may also be made of a piezoelectric or pyro-electric or magnetic material.

For example, the thickness of the layer 34 may be between 50 nm and 500 nm or 1 µm and the layer 61 may be between 10 nm and 1 µm or 50 µm thick. These thicknesses may also vary outside the ranges mentioned above.

The second buried layer 34 comprises one or several buried areas made of a second material 56, 58 different from the first material in layer 34, the essential difference being the behaviour during a subsequent etching operation such as dry etching or wet etching; the etching rate of material 56, 58 is lower than the etching rate of the material in layer 34, which is itself greater than the etching rate of the layer 61.

In other words, production of one or several openings 12 as described above with reference to Figure 2A, will make it possible to preferentially etch the first material which initially formed the layer 34 with an etching rate greater than the etching rate of the material 56, 58. For example, the ratio of the etching rates of the first material and the second material 56, 58 is greater than 1 or 2, or is between 2 and 10 or between 10 and 1000 and possibly even more than 1000.

Table I above gives typical etching rates for a few materials and for some chemical etching solutions.

The areas outside areas containing the second material 56, 58 are shown as a side view in Figure 5G. But, as illustrated in Figure 3B, their shape may be square in a plane parallel to a principal plane of the component or the layer 34, or they may have any other shape (circular, polygonal, elliptical, etc.) in the same plane. Since etching will act preferentially on the material other than material 56, 58, therefore it will be possible to make cavities of any shapes and particular square or circular or polygonal or elliptical cavities, etc.

The second buried layer 60 is composed of the same material as the material 56, 58 or another material but also with an etching rate lower than the etching rate of the first material in the layer 34.

Therefore, etching of this first material in layer 34 will leave anchor pads of material 56, 58 and a subjacent layer 60. These pads and the layer 60 provide mechanical anchorage and stability for the surface layer 61 on the substrate 72. Therefore, these means increase the solidity of the assembly.

A process for making such a component will now be described with reference to Figures 5A to 5G.

A first layer 34 made of a first material, for example an insulating material (Figure 5B) for example silicon oxide (SiO₂) for example obtained by thermal oxidation or LPCVD or PECVD, is made on a blank silicon wafer (Figure 5A). For example, the thickness of this layer may be about 1 µm.

Areas 52, 54 are defined on this wafer 6 by lithography, and these areas will define the areas of future cavities (Figure 5C), for example by chemical etching (for example by 10% HF) or RIE etching.

The material 34 is etched in these areas so as to completely eliminate it and to form these cavities.

The second material 56, 58 is then deposited in these cavities (Figure 5D) and this material is etched at rates lower than the etching rate of the first material 34.

This second material 56, 58 may for example be silicon nitride or polycrystalline Si if the layer 34 or the first material from which it is made is a silicon oxide SiO₂. This second material is chosen so that it behaves differently than the first material, particularly while etching during which gases or the solution preferentially etch the silicon oxide.

This deposition step is continued so as to leave a surface layer or film 60, that can then be levelled (Figure 5E), for example by mechanical - chemical polishing or using one of the levelling techniques already mentioned above.

Therefore, this film 60 may also be made of polycrystalline Si if the second material 56, 58 is already made of Si - poly.

Note that the material from which the layer 60 is made may be different from the material(s) 56, 58, but its etching rate will be lower than the etching rate of the first material 34.

Levelling then takes place on a uniform surface and therefore under optimum conditions, unlike the case described above with reference to Figure 4^{E} in which it takes place on a surface composed of two materials with different mechanical properties related to polishing.

Therefore, at the end of levelling there will be a layer 60 made of the second material.

This wafer thus prepared is then bonded onto or is assembled with another wafer 72 that may for example be made of blank silicon (Figure 5F).

A bonding layer 74 may previously have been deposited either on the substrate 72 or on the layer 60.

Molecular bonding between substrate 72 and the surface of the layer 60 will benefit from optimum levelling made on a uniform surface as described above. The layer 60 then becomes a buried layer.

In one variant, two wafers can be assembled with areas defined on each. For example, there are components on the surface of wafer 72 that have already been made and will come into contact with facing areas on which pads are to be made (on the side that will be assembled with the layer 60). In the latter case, the two wafers can be aligned with each other.

The result is then a structure including a "structured" buried layer 34, comprising areas filled with a first material that can be etched more easily than the second material 56, 58 and more easily than the material from which the second layer 60 is made.

At least one of the two wafers 6, 72 may be thinned to obtain a membrane 61 (Figure 5G) with the required thickness, for example made of monocrystalline silicon.

One or more wafers may be thinned by different means chosen from among-the means already mentioned as examples above.

The component or the substrate obtained may act as an initial material for making a micro-system in layer 61, using the technique described above with reference to Figures 2A - 2D. Thus, due to the presence of material 56, 58 in the buried layer 34, the process for obtaining buried cavities is simpler than in prior art and can be used to obtain much better controlled geometries in the plane of layer 34, and particularly with any shape, circular or square or rectangular or elliptical, or any other shape defined by the lithography and etching step of layer 34.

Any number of cavities with different shapes can be made in the same layer 34.

Furthermore, two cavities in the same layer may be filled with different materials, these two materials having different etching characteristics compared with the material in layer 34, and particularly their etching rates are lower than the etching rate of the layer 34.

Furthermore, the pads 56, 58 that remain after the first material has been etched provide anchor pads and stability for the resulting device. If they are conducting, they may also provide electrical continuity.

## Claims

1. Process for making a structure comprising a surface layer (2, 61), at least one buried layer (4, 34) and a support (6, 72), this process comprising:
- a first step to make a first structure, including the formation of a first layer (4, 34) made of a first material on a first support (6), and at least one area (26, 28, 56, 58) in this first layer made of a second material with an etching rate different from the etching rate of the first material,
- then a second step for the formation of the surface layer (2, 61), by assembly of the first structure with a second support (32, 72).

2. Process according to claim 1, also comprising thinning of at least one of the two supports.

3. Process according to claim 1 or 2, comprising etching of the first layer (4, 34) to form at least one cavity (22, 24, 52, 54), followed by deposition of the second material in the cavity(ies).

4. Process according to one of claims 1 to 3, the assembly being made by molecular bonding or by gluing.

5. Process according to one of claims 1 to 4, also including a step to produce at least one opening (12) in the surface layer (2, 61), opening up in the material of the buried layer (4, 34) with the highest etching rate.

6. Process according to claim 5, also including etching of the material with the highest etching rate, to form at least one cavity (22, 24, 52, 54) in the buried layer (4, 34).

7. Process according to claim 6, the cavity having a circular or square or rectangular or polygonal or elliptical shape or with at least one right angle in a plane parallel to the plane of the subjacent (4, 34) and surface (2, 61) layers.

8. Process according to one of claims 1 to 7, the material with the highest etching rate being made of silicon dioxide or thermal silica or polycrystalline silicon or amorphous silicon or silicon nitride.

9. Process according to one of claims 1 to 8, the material with the lower etching rate being made of Si₃N₄ or doped silicon dioxide of the BPSG or PSG type or SiO₂.

10. Process according to one of claims 1 to 9, the surface layer (2, 61) being made of a semiconductor, for example silicon or germanium, or a III-V or II-VI semiconductor or a semiconductor compound for example SiGe.

11. Process according to one of claims 1 to 10, the surface layer (2, 61) being made of a piezoelectric or pyro-electric or magnetic material.

12. Process according to one of claims 1 to 11, also comprising a step for formation of at least a part of an electronic or microelectronic or electromechanical or MEMS component (18) in the surface layer (2, 61).

13. Process according to one of claims 1 to 12, the second material having an etching rate greater than the etching rate of the first material.

14. Process according to claim 13, the surface layer being made by assembly of the first layer with the second support (32).

15. Process according to one of claims 1 to 12, the second material having an etching rate lower than the etching rate of the first material.

16. Process according to claim 15, also comprising a step for formation of a second layer (60) made of a third material with a lower etching rate than the first material, on the first layer including the first and second materials.

17. Process according to claim 16, the second and third materials being identical and being deposited during the same step.

18. Process according to one of claims 15 to 17, the surface layer being made by assembly of the second layer with the second support (72).

19. Process according to one of claims 1 to 18, also comprising a polishing step before formation of the surface layer (2, 61).

20. Process according to one of claims 1 to 19, the side of the surface of said second support to be assembled with said first layer comprising components that will come into contact with said at least one area in said first layer, both wafers being aligned with each other when assembling said first structure with said second support.

21. Device comprising a blank surface layer (2), at least one buried layer (4) made of a first material, and a support (6),
**characterized in that**:
the buried layer comprises at least one area (26, 28) made of a second material, with an etching rate different from the etching rate of the first material.

22. Device according to claim 21, at least one of the areas made of a second material having a circular or square or rectangular or polygonal or elliptical shape or at least one right angle in a plane parallel to the plane of the buried layer (4) and surface layer (2).

23. Device according to one of claims 21 or 22, the material with the lower etching rate being an electrical insulator such as silicon dioxide, or thermal silica or polycrystalline silicon or amorphous silicon or silicon nitride.

24. Device according to one of claims 21 to 23, the material with the highest etching rate being made of Si₃N₄ or doped silicon dioxide of the BPSG or PSG type or SiO₂.

25. Device according to one of claims 21 to 24, the surface layer (2, 61) being made of a semiconductor, for example silicon or germanium, or a III-V or II-VI semiconductor or a semiconductor compound for example SiGe.

26. Device according to one of claims 21 to 25, the surface layer (2) being made of a piezoelectric, or pyro-electric or magnetic material.

27. Device according to one of claims 21 to 26, the second material having an etching rate higher than the first material.

28. Device according to one of claims 21 to 27, the second material having an etching rate lower than the first material.

29. Device according to claim 28, also comprising a second buried layer (60) made of a third material with an etching rate lower than the first material.

30. Device according to claim 29, the second and third materials being identical.

31. Device according to one of claims 21 to 30, the ratio of the highest etching rate to the lowest etching rate being greater than 10.

32. Semiconducting device comprising a surface layer (2, 61), a first buried layer (4) comprising areas made of a first material (56, 58) and at least one cavity,
**characterized in that**:
said at least one cavity has a square or rectangular or polygonal or elliptical shape or has at least one right angle in a plane parallel to the plane of the buried layer (4) and layer surface (2), said device having a second buried layer (60) made of a second material and a support (6).

33. Device according to claim 32, the surface layer (2) being made of a semiconductor, for example silicon or germanium, or a III-V or II-VI semiconductor or a semiconductor compound for example SiGe.

34. Device according to one of claims 32 or 33, the surface layer (2) being made of a piezoelectric, or pyro-electric or magnetic material.

35. Device according to one of claims 32 to 34, also comprising all or part of an electronic or microelectronic or electromechanical or MEMS component (18) in the surface layer (2), above the cavity formed in the buried layer.

36. Device comprising a surface layer (2), at least one buried layer (4), made of a first material, and a support (6), the buried layer comprising at least two areas (26, 28),
**characterized in that**:
one of said at least two areas is made of a second material, and the other one is made of a third material, different from said second material, said second and third materials having etching rates different from the etching rate of the first material, a second buried layer (60) made of a material having an etching rate lower than the etching rate of the first material.

37. Device according to claim 36, said second and third materials having etching rates greater than the etching rate of the first material.

38. Device according to claim 36, said second and third materials having etching rates lower than the etching rate of the first material.

## Patentansprüche

1. Verfahren zum Herstellen einer Struktur, die eine Oberflächenschicht (2, 61), wenigstens eine vergrabene Schicht (4, 34) und einen Träger (6, 72) umfasst, wobei dieses Verfahren umfasst:
- einen ersten Schritt zum Herstellen einer ersten Struktur, der die Ausbildung einer ersten Schicht (4, 34), die aus einem ersten Material besteht, auf einem ersten Träger (6) und wenigstens eines Bereiches (26, 28, 56, 58) in dieser ersten Schicht einschließt, der aus einem zweiten Material mit einer Ätzrate besteht, die sich von der Ätzrate des ersten Materials unterscheidet,
- danach einen zweiten Schritt zur Ausbildung der Oberflächenschicht (2, 61) durch Zusammensetzen der ersten Struktur und eines zweiten Trägers (32, 72).

2. Verfahren nach Anspruch 1, das des Weiteren Verdünnen wenigstens eines der zwei Träger umfasst.

3. Verfahren nach Anspruch 1 oder 2, das Ätzen der ersten Schicht (4, 34) zum Ausbilden wenigstens eines Hohlraums (22, 24, 52, 54), gefolgt von Abscheiden des zweiten Materials in dem/den Hohlraum/Hohlräumen, umfasst.

4. Verfahren nach einem der Ansprüche 1 bis 3, wobei das Zusammensetzen mittels Molekularbindung oder mittels Verkleben vorgenommen wird.

5. Verfahren nach einem der Ansprüche 1 bis 4, das des Weiteren einen Schritt zum Erzeugen wenigstens einer Öffnung (12) in der Oberflächenschicht (2, 61) einschließt, die sich in dem Material der vergrabenen Schicht (4, 34) mit der höchsten Ätzrate nach oben öffnet.

6. Verfahren nach Anspruch 5, das des Weiteren Ätzen des Materials mit der höchsten Ätzrate zum Ausbilden wenigstens eines Hohlraums (22, 24, 52, 54) in der vergrabenen Schicht (4, 34) einschließt.

7. Verfahren nach Anspruch 6, wobei der Hohlraum die Form eines Kreises oder Quadrates oder Rechtecks oder Polygons oder einer Ellipse hat oder wenigstens einen rechten Winkel in einer Ebene parallel zur Ebene der darunterliegenden Schichten (4, 34) und der Oberflächenschicht (2, 61) hat.

8. Verfahren nach einem der Ansprüche 1 bis 7, wobei das Material mit der höchsten Ätzrate aus Siliziumdioxid oder thermischen Siliziumdioxid oder polykristallinem Silizium oder amorphem Silizium oder Siliziumnitrid besteht.

9. Verfahren nach einem der Ansprüche 1 bis 8, wobei das Material mit der niedrigeren Ätzrate aus Si₃N₄ oder dotiertem Siliziumdioxid vom BPSG- oder PSG-Typ oder SiO₂ besteht.

10. Verfahren nach einem der Ansprüche 1 bis 9, wobei die Oberflächenschicht (2, 61) aus einem Halbleiter, beispielsweise Silizium oder Germanium, oder einem III-V- oder II-VI-Halbleiter oder einer Halbleiterverbindung, beispielsweise SiGe, besteht.

11. Verfahren nach einem der Ansprüche 1 bis 10, wobei die Oberflächenschicht (2, 61) aus einem piezoelektrischen oder pyroelektrischen oder magnetischen Material besteht.

12. Verfahren nach einem der Ansprüche 1 bis 11, das des Weiteren einen Schritt zum Ausbilden wenigstens eines Teils einer elektronischen oder mikroelektronischen oder elektromechanischen oder mikroelektromechanischen Komponente (18) in der Oberflächenschicht (2, 61) umfasst.

13. Verfahren nach einem der Ansprüche 1 bis 12, wobei das zweite Material eine Ätzrate hat, die höher ist als die Ätzrate des ersten Materials.

14. Verfahren nach Anspruch 13, wobei die Oberflächenschicht durch Zusammensetzen der ersten Schicht und des zweiten Trägers (32) entsteht.

15. Verfahren nach einem der Ansprüche 1 bis 12, wobei das zweite Material eine Ätzrate hat, die niedriger ist als die Ätzrate des ersten Materials.

16. Verfahren nach Anspruch 15, das des Weiteren einen Schritt zum Ausbilden einer zweiten Schicht (60), die aus einem dritten Material mit einer niedrigeren Ätzrate als der des ersten Materials besteht, auf der ersten Schicht umfasst, die das erste und das zweite Material enthält.

17. Verfahren nach Anspruch 16, wobei das zweite und das dritte Material identisch sind und während des gleichen Schritts abgeschieden werden.

18. Verfahren nach einem der Ansprüche 15 bis 17, wobei die Oberflächenschicht durch Zusammensetzen der zweiten Schicht und des zweiten Trägers (72) erzeugt wird.

19. Verfahren nach einem der Ansprüche 1 bis 18, das des Weiteren einen Polierschritt vor dem Ausbilden der Oberflächenschicht (2, 61) umfasst.

20. Verfahren nach einem der Ansprüche 1 bis 19, wobei die Seite der Oberfläche des zweiten Trägers, die mit der ersten Schicht zusammengesetzt wird, Komponenten umfasst, die mit dem wenigstens einen Bereich in der ersten Schicht in Kontakt kommen, und wobei beide Wafer aufeinander ausgerichtet werden, wenn die erste Struktur und der zweite Träger zusammengesetzt werden.

21. Vorrichtung, die eine leere Oberflächenschicht (2), wenigstens eine vergrabene Schicht (4), die aus einem ersten Material besteht, und einen Träger (6) umfasst,
**dadurch gekennzeichnet, dass**
die vergrabene Schicht wenigstens einen Bereich (26, 28) umfasst, der aus einem zweiten Material mit einer Ätzrate besteht, die sich von der Ätzrate des ersten Materials unterscheidet.

22. Vorrichtung nach Anspruch 21, wobei wenigstens einer der Bereiche, die aus einem zweiten Material bestehen, die Form eines Kreises oder Quadrates oder Rechtecks oder Polygons oder einer Ellipse hat oder wenigstens einen rechten Winkel in einer Ebene parallel zur Ebene der vergrabenen Schicht (4) und der Oberflächenschicht (2) hat.

23. Vorrichtung nach einem der Ansprüche 21 oder 22, wobei das Material mit der niedrigeren Ätzrate ein elektrischer Isolator, wie beispielsweise Siliziumdioxid, oder thermisches Siliziumdioxid oder polykristallines Silizium oder amorphes Silizium oder Siliziumnitrid ist.

24. Vorrichtung nach einem der Ansprüche 21 bis 23, wobei das Material mit der höchsten Ätzrate aus Si₃N₄ oder dotiertem Siliziumdioxid vom BPSG- oder PSG-Typ oder SiO₂ besteht.

25. Vorrichtung nach einem der Ansprüche 21 bis 24, wobei die Oberflächenschicht (2, 61) aus einem Halbleiter, beispielsweise Silizium oder Germanium, oder einem III-V- oder II-VI-Halbleiter oder einer Halbleiterverbindung, beispielsweise SiGe, besteht.

26. Vorrichtung nach einem der Ansprüche 21 bis 25, wobei die Oberflächenschicht (2) aus einem piezoelektrischen oder pyroelektrischen oder magnetischen Material besteht.

27. Vorrichtung nach einem der Ansprüche 21 bis 26, wobei das zweite Material eine Ätzrate hat, die höher ist als die des ersten Materials.

28. Vorrichtung nach einem der Ansprüche 21 bis 27, wobei das zweite Material eine Ätzrate hat, die niedriger ist als die des ersten Materials.

29. Vorrichtung nach Anspruch 28, die des Weiteren eine zweite vergrabene Schicht (60) umfasst, die aus einem dritten Material mit einer Ätzrate besteht, die niedriger ist als die des ersten Materials.

30. Vorrichtung nach Anspruch 29, wobei das zweite und das dritte Material identisch sind.

31. Vorrichtung nach einem der Ansprüche 21 bis 30, wobei das Verhältnis der höchsten Ätzrate zu der niedrigsten Ätzrate größer ist als 10.

32. Halbleitervorrichtung, die eine Oberflächenschicht (2, 61), eine erste vergrabene Schicht (4), die Bereiche umfasst, die aus einem ersten Material (56, 58) bestehen, und wenigstens einen Hohlraum umfasst,
**dadurch gekennzeichnet, dass**
der wenigstens eine Hohlraum die Form eines Quadrates oder Rechtecks oder Polygons oder einer Ellipse hat oder wenigstens einen rechten Winkel in einer Ebene parallel zu der Ebene der vergrabenen Schicht (4) und der Oberflächenschicht (2) hat, und die Vorrichtung eine zweite vergrabene Schicht (60), die aus einem zweiten Material besteht, und einen Träger (6) hat.

33. Vorrichtung nach Anspruch 32, wobei die Oberflächenschicht (2) aus einem Halbleiter, beispielsweise Silizium oder Germanium, oder einem III-V- oder II-VI-Halbleiter oder einer Halbleiterverbindung, beispielsweise SiGe, besteht.

34. Vorrichtung nach einem der Ansprüche 32 oder 33, wobei die Oberflächenschicht (2) aus einem piezoelektrischen oder pyroelektrischen oder magnetischen Material besteht.

35. Vorrichtung nach einem der Ansprüche 32 bis 34, die des Weiteren alle oder einen Teil von einer elektronischen oder mikroelektronischen oder elektromechanischen oder mikroelektromechanischen Komponente (18) in der Oberflächenschicht (2) oberhalb des in der vergrabenen Schicht ausgebildeten Hohlraums umfasst.

36. Vorrichtung, die eine Oberflächenschicht (2), wenigstens eine vergrabene Schicht (4), die aus einem ersten Material besteht, und einen Träger (6) umfasst, wobei die vergrabene Schicht wenigstens zwei Bereiche (26, 28) umfasst,
**dadurch gekennzeichnet, dass**
einer der wenigstens zwei Bereiche aus einem zweiten Material besteht und der andere aus einem dritten Material besteht, das sich von dem zweiten Material unterscheidet, wobei das zweite und das dritte Material Ätzraten haben, die sich von der Ätzrate des ersten Materials unterscheiden, und eine zweite vergrabene Schicht (60) aus einem Material besteht, das eine Ätzrate hat, die niedriger ist als die Ätzrate des ersten Materials.

37. Vorrichtung nach Anspruch 36, wobei das zweite und das dritte Material Ätzraten haben, die höher sind als die Ätzrate des ersten Materials.

38. Vorrichtung nach Anspruch 36, wobei das zweite und das dritte Material Ätzraten haben, die niedriger sind als die Ätzrate des ersten Materials.

## Revendications

1. Procédé de réalisation d'une structure comportant une couche superficielle (2, 61), au moins une couche enterrée (4, 34) et un support (6, 72), ce procédé comportant :
- une première étape pour réaliser une première structure, comportant la formation d'une première couche (4, 34) constituée d'un premier matériau sur un premier support (6), et d'au moins une zone (26, 28, 56, 58) dans cette première couche constituée d'un deuxième matériau avec une vitesse de gravure différente de la vitesse de gravure du premier matériau,
- ensuite, une deuxième étape pour la formation de la couche superficielle (2, 61), par l'assemblage de la première structure avec un deuxième support (32, 72).

2. Procédé selon la revendication 1, comportant en outre un amincissement d'au moins l'un des deux supports.

3. Procédé selon la revendication 1 ou 2, comportant une gravure de la première couche (4, 34) pour former au moins une cavité (22, 24, 52, 54), suivie par le dépôt du deuxième matériau dans la ou les cavités.

4. Procédé selon l'une des revendications 1 à 3, l'assemblage étant effectué par adhésion moléculaire ou par collage.

5. Procédé selon l'une des revendications 1 à 4, comportant également une étape pour produire au moins une ouverture (12) dans la couche superficielle (2, 61), débouchant dans le matériau de la couche enterrée (4, 34) qui a la vitesse de gravure la plus élevée.

6. Procédé selon la revendication 5, comportant en outre une gravure du matériau qui a la vitesse de gravure la plus élevée, pour former au moins une cavité (22, 24, 52, 54) dans la couche enterrée (4, 34).

7. Procédé selon la revendication 6, la cavité présentant une forme circulaire ou carrée ou rectangulaire ou polygonale ou elliptique ou avec au moins un angle droit dans un plan parallèle au plan des couches sous-jacentes (4, 34) et superficielle (2, 61).

8. Procédé selon l'une des revendications 1 à 7, le matériau à vitesse de gravure la plus élevée étant en dioxyde de silicium ou en silice thermique ou en silicium polycristallin ou de silicium amorphe ou en nitrure de silicium.

9. Procédé selon l'une des revendications 1 à 8, le matériau à la vitesse de gravure plus faible étant en Si₃N₄ ou en dioxyde de silicium dopé du type BPSG ou PSG ou en SiO₂.

10. Procédé selon l'une des revendications 1 à 9, la couche superficielle (2, 61) étant en semi-conducteur, par exemple en silicium ou en germanium, ou en un semi-conducteur III-V ou II-VI ou en un semi-conducteur composé, par exemple en SiGe.

11. Procédé selon l'une des revendications 1 à 10, la couche superficielle (2, 61) étant en un matériau piézoélectrique ou pyroélectrique ou magnétique.

12. Procédé selon l'une des revendications 1 à 11, comportant également une étape pour la formation d'au moins une partie d'un composant électronique ou microélectronique ou électromécanique ou MEMS (18) dans la couche superficielle (2, 61).

13. Procédé selon l'une des revendications 1 à 12, le deuxième matériau ayant une vitesse de gravure supérieure à la vitesse de gravure du premier matériau.

14. Procédé selon la revendication 13, la couche superficielle étant réalisée par l'assemblage de la première couche avec le deuxième support (32).

15. Procédé selon l'une des revendications 1 à 12, le deuxième matériau ayant une vitesse de gravure inférieure à la vitesse de gravure du premier matériau.

16. Procédé selon la revendication 15, comportant également une étape pour la formation d'une deuxième couche (60) constituée d'un troisième matériau avec une vitesse de gravure inférieure à celle du premier matériau, sur la première couche comportant les premier et deuxième matériaux.

17. Procédé selon la revendication 16, les deuxième et troisième matériaux étant identiques et étant déposés pendant la même étape.

18. Procédé selon l'une des revendications 15 à 17, la couche superficielle étant réalisée par assemblage de la deuxième couche avec le deuxième support (72).

19. Procédé selon l'une des revendications 1 à 18, comportant en outre une étape de polissage avant la formation de la couche superficielle (2, 61).

20. Procédé selon l'une des revendications 1 à 19, le côté de la surface dudit deuxième support à assembler avec ladite première couche comportant des composants qui viendront en contact avec ladite au moins une zone dans ladite première couche, les deux supports étant alignés l'un avec l'autre lors de l'assemblage de ladite première structure avec ledit deuxième support.

21. Dispositif comportant une couche superficielle (2) vierge, au moins une couche enterrée (4) constituée d'un premier matériau, et un support (6),
**caractérisé en ce que** :
la couche enterrée comprend au moins une zone (26, 28) constituée d'un deuxième matériau, avec une vitesse de gravure différente de la vitesse de gravure du premier matériau.

22. Dispositif selon la revendication 21, au moins l'une des zones constituées d'un deuxième matériau présentant une forme circulaire ou carrée ou rectangulaire ou polygonale ou elliptique ou au moins un angle droit dans un plan parallèle au plan de la couche enterrée (4) et de la couche superficielle (2).

23. Dispositif selon l'une des revendications 21 ou 22, le matériau avec la vitesse de gravure plus faible étant un isolant électrique tel que du dioxyde de silicium, ou de a silice thermique ou du silicium polycristallin ou du silicium amorphe ou du nitrure de silicium.

24. Dispositif selon l'une des revendications 21 à 23, le matériau avec la vitesse de gravure la plus élevée étant constitué de Si₃N₄ ou de dioxyde de silicium dopé du type BPSG ou PSG ou de SiO₂.

25. Dispositif selon l'une des revendications 21 à 24, la couche superficielle (2, 61) étant constituée d'un semi-conducteur, par exemple du silicium ou du germanium, ou d'un semi-conducteur III-V ou II-VI ou d'un semi-conducreur composé, par exemple du SiGe.

26. Dispositif selon l'une des revendications 21 à 25, la couche superficielle (2) étant en un matériau piézoélectrique ou pyroélectrique ou magnétique.

27. Dispositif selon l'une des revendications 21 à 26, le deuxième matériau ayant une vitesse de gravure supérieure à celle du premier matériau.

28. Dispositif selon l'une des revendications 21 à 27, le deuxième matériau ayant une vitesse de gravure inférieure à celle du premier matériau.

29. Dispositif selon la revendication 28, comportant également une deuxième couche enterrée (60) constituée d'un troisième matériau avec une vitesse de gravure inférieure à celle du premier matériau.

30. Dispositif selon la revendication 29, les deuxième et troisième matériaux étant identiques.

31. Dispositif selon l'une des revendications 21 à 30, le rapport entre la vitesse de gravure la plus élevée et la vitesse de gravure la plus faible étant supérieur à 10.

32. Dispositif semi-conducteur comportant une couche superficielle (2, 61), une première couche enterrée (4) comportant des zones constituées d'un premier matériau (56, 58) et au moins une cavité,
**caractérisé en ce que :**
ladite au moins une cavité présente une forme carrée ou rectangulaire ou polygonale ou elliptique ou comporte au moins un angle droit dans un plan parallèle au plan de la couche enterrée (4) et de la couche superficielle (2), ledit dispositif comportant une deuxième coche enterrée (60) constituée d'un deuxième matériau et un support (6).

33. Dispositif selon la revendication 32, la couche superficielle (2) étant en un semi-conducteur, par exemple en silicium ou en germanium, ou en un semi-conducteur III-V ou II-VI ou en un semi-conducteur composé, par exemple en SiGe.

34. Dispositif selon l'une des revendications 32 ou 33, la couche superficielle (2) étant en un matériau piézoélectrique, ou pyroélectrique ou magnétique.

35. Dispositif selon l'une des revendications 32 à 34, comportant également la totalité ou une partie d'un composant électronique ou microélectronique ou électromécanique ou MEMS (18) dans la couche superficielle (2), au-dessus de la cavité formée dans la couche enterrée.

36. Dispositif comportant une couche superficielle (2), au moins une couche enterrée (4), constituée d'un premier matériau, et un support (6), la couche enterrée comportant au moins deux zones (26, 28),
**caractérisé en ce que :**
l'une desdites au moins deux zones est en un deuxième matériau, et l'autre est en un troisième matériau, différent dudit deuxième matériau, lesdits deuxième et troisième matériaux ayant des vitesses de gravure différentes de la vitesse de gravure du premier matériau, une deuxième couche enterrée (60) en un matériau ayant une vitesse de gravure inférieure à la vitesse de gravure du premier matériau.

37. Dispositif selon la revendication 36, lesdits deuxième et troisième matériaux ayant des vitesses de gravure supérieures à la vitesse de gravure du premier matériau.

38. Dispositif selon la revendication 36, lesdits deuxième et troisième matériaux ayant des vitesses de gravure inférieures à la vitesse de gravure du premier matériau.
